Europäisches Patentamt

European Patent Office

Office européen des brevets

(19)

(11) Veröffentlichungsnummer: **0 074 536**
**B1**

(12) # EUROPÄISCHE PATENTSCHRIFT

(45) Veröffentlichungstag der Patentschrift:
01.07.87

(21) Anmeldenummer: **82107852.4**

(22) Anmeldetag: **26.08.82**

(51) Int. Cl.⁴: **H 03 K 17/64, F 02 D 5/02**

(54) Elektrische Schaltanordnung in Verbindung mit einem Kfz-Steuergerät.

(30) Priorität: **10.09.81 DE 3135805**

(43) Veröffentlichungstag der Anmeldung:
**23.03.83 Patentblatt 83/12**

(45) Bekanntmachung des Hinweises auf die Patenterteilung:
**01.07.87 Patentblatt 87/27**

(84) Benannte Vertragsstaaten:
**DE FR GB IT**

(56) Entgegenhaltungen:
EP-A-0 009 370
FR-A-2 456 106
GB-A-2 048 596
US-A-3 724 430
US-A-3 916 220

ELECTRONICS INTERNATIONAL, Band 51, Nr. 13,
Juni 1978, Seiten 105-112, New York, USA, A.D.
EVANS et al.:"Higher power ratings extend V-MOS
FETs' dominion"

(73) Patentinhaber: **ROBERT BOSCH GMBH, Postfach
50, D-7000 Stuttgart 1 (DE)**

(72) Erfinder: **Arnold, Winfried, Lärchenweg 50, D-7143
Vaihingen/Enz (DE)**
Erfinder: **Locher, Johannes, Möwenweg 50, D-7000
Stuttgart 50 (DE)**
Erfinder: **Schelling, Bernd, Triebweg 123, D-7000
Stuttgart 30 (DE)**

## Beschreibung

Die Erfindung betrifft eine elektrische Schaltanordnung zur getakteten Regelung des Stromes durch einen elektromagnetischen Verbraucher in Verbindung mit einem Kraftfahrzeug.

## Stand der Technik

Brennkraftmaschinen mit Fremdzündung werden zunehmend mit intermittierend arbeitenden Einspritzsystemen ausgestattet. Die Dosierung der Kraftstoffmenge erfolgt dabei durch gesteuerte Öffnungszeiten von elektromagnetisch betätigbaren Einspritzventilen. Zur genauen Dosierung der eingespritzten Kraftstoffmenge ist es erforderlich, sehr schnell schaltende Einspritzventile vorzusehen. Erreichen läßt sich dies u.a. durch hohe Schaltströme zumindest im Einschaltmoment des Magnetventils. Aus Verlustleistungsgründen ist nun seit langem bekannt, zu Beginn der Öffnungsperiode eines elektromagnetischen Einspritzventils einen hohen Strom durch die Magnetwicklung zu schicken und anschließend diesen Strom auf den sogenannten Haltestrom abzusenken, bis am Ende des Einspritzimpulses auch der Haltestrom abgeschaltet wird. Um nun einen möglichst niedrigen Haltestrom einstellen zu können, ist eine Regelung dieses Stromes erforderlich. Dazu dient ein Strommeßwiderstand in Reihe zur Erregerwicklung des Magnetventils und einem Stromsteuerorgan (in der Regel in Form eines Transistors) und über den Spannungsabfall am Meßwiderstand läßt sich dann der Strom durch die Magnetwicklung auf einen speziellen Wert einregeln. Bei einer bekannten elektrischen Schaltungsanordnung liegen zwischen den beiden Batteriespannungsanschlüssen drei Bauelemente:
Magnetwicklung des Einspritzventils, Stromsteuerorgan und Meßwiderstand. Besonders im Hinblick auf einfache Systeme ist der Meßwiderstand nicht wünschenswert, da er in der Regel für hohe Leistungen bei niedrigem Widerstandswert ausgelegt sein muß und somit bei der Kalkulation der Schaltungsanordnung nicht unwesentlich ins Gewicht fällt.

Aus der FR-A-1 24 58 106 ist weiter eine elektrische Schaltungsanordnung in Verbindung mit einem Kraftfahrzeugsteuergerät mit einem elektrischen, insbesondere induktiven Verbraucher sowie einem Feldeffekttransistor als Schalter bekannt. Dort dient jedoch der als Schalttransistor verwendete Feldeffekttransistor nicht gleichzeitig der Messung des den Verbraucher durchfließenden Stromes. Vielmehr werden lediglich die logischen Signale am Eingang der Schaltungsanordnung sowie an der Verbindungßstelle von Schalttransistor und elektromagnetischem Verbraucher miteinander verknüpft. Im übrigen arbeitet die Schaltungsanordnung als eine monostabile Kippstufe im Fall des Zurückschaltens des Eingangssignals von einem hohen auf einen niedrigen Pegel.

## Vorteile der Erfindung

Mit der erfindungsgemäßen Schaltungsanordnung läßt sich der bisher notwendige Meßwiderstand einsparen, ohne eine Qualitätseinbuße in Kauf nehmen zu müssen. Vor allem im Hinblick auf die Wärmeentwicklung infolge der unvermeidlichen Verlustleistung ist dies ein nicht zu unterschätzender Vorteil, der vor allem dann zum Tragen kommt, wenn eine große Packungsdichte der einzelnen Bauelemente angestrebt wird. Weitere Vorteile der Erfindung ergeben sich in Verbindung mit der Beschreibung von Ausführungsbeispielen.

## Zeichnung

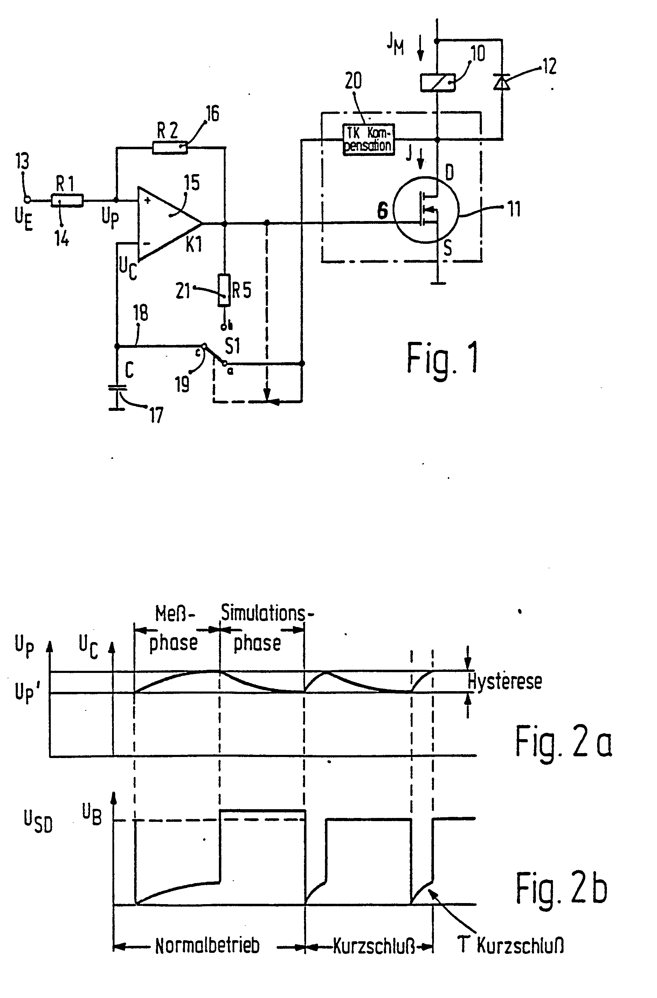

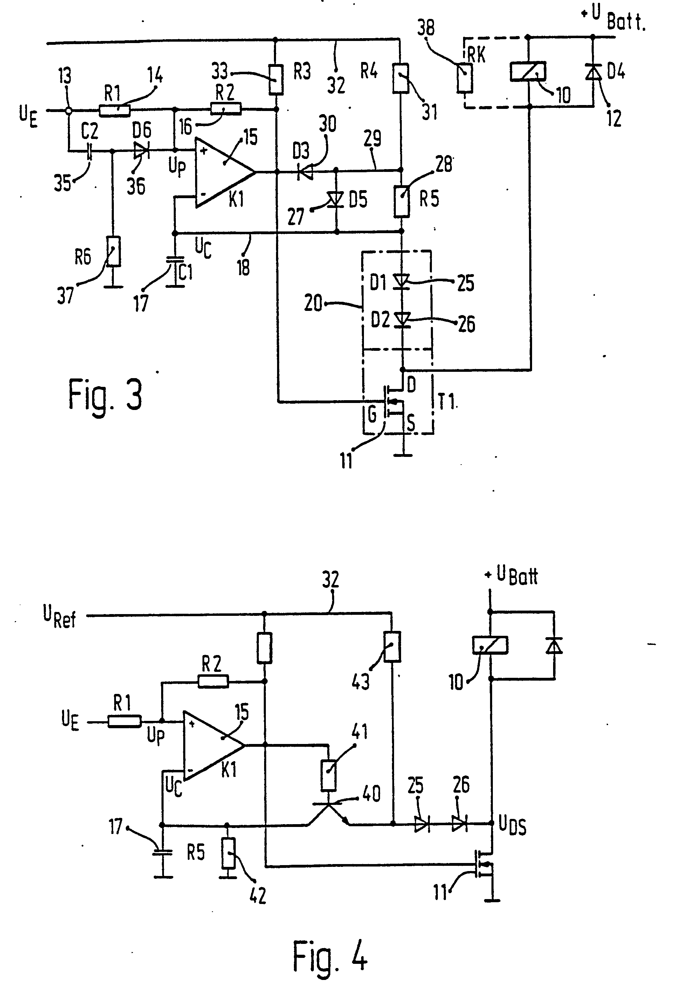

Ausführungsbeispiele der Erfindung sind in der Zeichnung dargestellt und werden im folgenden näher beschrieben und erläutert. Es zeigt Figur 1 das Grundprinzip einer Ansteuereinheit für ein elektromagnetisches Einspritzventil mit der erfindungsgemäßen Schaltungsanordnung, Figur 2 Diagramme zur Erläuterung der in Figur 1 dargestellten Schaltungsanordnung, Figur 3, 4 und 5 weitere Beispiele mit kleinen Modifikationen sowie eine Vielfachanordnung.

## Beschreibung der Ausführungsbeispiele

Die Ausführungsbeispiele betreffen Signalendstufen bei elektromagnetisch gesteuerten Einspritzsystemen bei Brennkraftmaschinen mit Fremdzündung. Diese Art der Endstufen sind auch unter der Bezeichung "stromgeregelte Endstufen" bekannt.

In Figur 1 ist mit 10 die Magnetwicklung eines elektromagnetischen Einspritzventils bezeichnet, zu der in Reihe ein Feldeffekttransistor 11 geschaltet ist. Diese Reihenschaltung liegt zwischen zwei nicht näher gekennzeichneten Batterieanschlüssen. Parallel zur Magnetwicklung 10 befindet sich noch eine Freilaufdiode 12. Von einer Eingangsklemme 13 führt ein Widerstand 14 zum Plus-Eingang eines Operationsverstärkers 15, der ausgangsseitig mit dem Gate-Anschluß des Feldeffekttransistors 11 gekoppelt ist. Mitgekoppelt ist der Operationsverstärker 15 über einen Widerstand 16. Von seinem Minus-Eingang führt ein Kondensator 17 zu Masse und außerdem eine Leitung 18 zu einem Wechselschalter 19. In der gezeichneten Stellung des Wechselschalters 19 liegt der Kondensator 17 parallel zur Drain-Source-Strecke des Feldeffekttransistors 11. Dabei ist in dieser Verbindungsleitung in unmittelbarer Nachbarschaft des FET eine Temperaturkompensationsstufe 20 vorgesehen. In der anderen Schaltstellung des Wechselschalters 19 ermöglicht ein Widerstand 21 eine definierte Gegenkopplung des Operationsverstärkers 15. Strichpunktierte Linien in Verbindung mit dem Schalter 19 deuten an, daß dieser Schalter entweder mit dem Drain-Signal des FET 11 oder dem Ausgangssignal des Operationsverstärkers 15 schaltbar ist.

Erklärt wird der in Figur 1 dargestellte Gegenstand zweckmäßigerweise anhand der Figuren 2a und 2b. Dort zeigt 2a) den Spannungsverlauf über den Kondensator 17 und 2b) den Spannungsabfall über der Drain-Source-Strecke des Feldeffekttransistors 11.

Wesentlich ist nun, daß der Stromfluß durch die Magnetwicklung 10 des Einspritzventils während eines Einspritzimpulses getaktet wird. Der in Reihe zur Magnetwicklung liegende Feldeffekttransistor wird somit innerhalb der Impulsdauer eines Einspritzimpulses taktweise leitend oder in seinen Sperrzustand gesteuert. Während seiner leitenden Phase kann dieser Feldeffekttransistor nun als Stommeßwiderstand angesehen werden. Da während seiner Sperrphase durch ihn kein Strom fließt und somit über ihm auch keine Spannung abfällt, scheidet er in diesen Augenblicken als Strommeßwiderstand für den Magnetstrom aus und es muß eine Hilfsgröße für diesen Magnetventilstrom gebildet werden. Aus diesem Grund findet eine Simulation des Stromverlaufs durch die Magnetwicklung 10 während der Sperrphase des FET 11 statt, die mittels eines RC-Gliedes erfolgt. Während des leitenden Zustandes des FET 11 wird dazu der Kondensator 17 aufgeladen und während der nachfolgenden Sperrphase wieder entladen. Dies erfolgt über den Widerstand 21. In Figur 2 ist dieses fortlaufende Aufladen und Entladen des Kondensators 17 dargestellt, obei die entstehende Hysterese von der Dimensionierung der einzelnen Widerstände in Verbindung mit dem Operationsverstärker 15 abhängt. Die Stromflußphase durch den Feldeffekttransistor 11 entspricht dabei dem Signalteil mit steigendem Spannungsverlauf und die Simulationsphase demjenigen mit negativen Verlauf. Die in Figur 1 dargestellte prinzipielle Schaltungsanordnung ermöglicht somit entsprechend der Darstellung in den Figuren 2a und 2b während eines Einspritzimpulses ein Takten des Schalttransistors abhängig von einem erreichten Maximalwert des Stromes und einem simulierten Minimalwert.

Im Hinblick auf den zu Beginn einer Öffnungsphase des Einspritzimpulses erhöhten Leistungsbedarf ist es im Hinblick auf eine möglichst geringe Gesamtverlustleistung wünschenswert, diesen erhöhten Leistungsbedarf durch einen zu Beginn erhöhten Stromfluß durch das Magnetventil zu realisieren. Anschließend wird dann für die restliche Dauer des Einspritzimpulses die gemittelte Energie zurückgenommen, die dann nur noch so groß sein muß, um das Einspritzventil in seiner Offenstellung zu halten. Eine Realisierungsmöglichkeit für diesen Leistungsverlauf mit einer erfindungsgemäßen Schaltungsanordnung ist im einzelnen in Figur 3 dargestellt. Dabei sind die Einzelelemente, sofern sie mit denen von Figur 1 übereinstimmen, mit den gleichen Bezugzeichen versehen.

Beim Gegenstand von Figur 3 ist der Schalter 19 von Figur 1 mittels einer Diodenkombination realisiert. Die Leitung 18 steht beim Gegenstand von Figur 3 über zwei Diode 25 und 26 mit dem Drain-Anschluß des Feldeffekttransistors 11 in Verbindung und ferner über eine Parallelschaltung von Diode 27 und Widerstand 28 mit einer Verbindungsleitung 29, die einmal über eine Diode 30 mit dem Ausgang des Operationsverstärkers 15 und einmal über einen Widerstand 31 mit einer Plusleitung 32 gekoppelt ist. Der Ausgang des Operationsverstärkers 15 steht zusätzlich über einen Widerstand 33 mit der Plusleitung 32 in Verbindung.

Zur Reslisierung der anfänglichen Stromüberhöhung zur Bereitstellung eines ausreichenden Anzugsstroms für die Magnetwicklung 10 dient ein RC-Glied parallel zum Widerstand 14. Es besteht aus einer Reihenschaltung von Kondensator 35 und Diode 36, und die Verbindungsstelle dieser beiden Bauelemente ist über einen Widerstand 37 mit Masse verbunden. Schließlich ist parallel zur Magnetwicklung ein Widerstand 38 gestrichelt gezeichnet, der den ohmschen Widerstand der Magnetwicklung 11 repräsentiert.

Im einzelnen funktioniert die Schaltungsanordnung nach Figur 3 wie folgt.

Springt das Potential an der Eingangsklemme UE auf einen positiven Wert, dann schaltet der Operationsverstärker 15 durch, sein Ausgangswert geht ebenfalls nach oben und steuert den Feldeffekttranstistor 11 in seinen leitenden Zustand. An seinem Kanalwiderstand (Ron) fällt eine Spannung ab, die dem Strom durch die Magnetwicklung 10 proportional ist. Über den Widerstand 31 und die Diode 27 werden die Dioden 25 und 26 niederohmig vorgespannt. Das bedeutet, daß an der Anode der Diode 25 die Drain-Source-Spannung erhöht um die doppelte Durchlaßspannung der beiden Dioden 25 und 26 vorliegt und der Kondensator 17 dieser Spannung folgt. Dies entspricht der im Zusammenhang mit den Figuren 1 und 2 beschriebenen Meßphase. Erreicht die Spannung über dem Kondensator 17 die Schaltschwelle des als Komparator geschalteten Operationsverstärkers 15, dann geht dessen Ausgangswert auf tiefes Potential. Dadurch sperrt der Feldeffekttransistor 11 und der Strom durch die Magnetwicklung 10 baut sich über die Freilaufdiode 12 exponentiell ab. Gleichzeitig sind die beiden Dioden 25 und 26 in Sperrichtung gepolt. Die ursprüngliche Schwellwertspannung UP wird durch die beiden Widerstände 14 und 16 auf einen niedrigeren Pegel UP2 geschaltet und es entsteht die aus Figur 2 ersichtliche Hysterese. Der Kondensator 17 kann sich nun über den Widerstand 28 und die Diode 30 sowie den Ausgang des Operationsverstärkers 15 entladen. Mit dem Widerstandswert des Widerstandes 28 läßt sich hierbei die Entladezeit variieren und somit an den zeitlichen Stromverlauf durch die Magnetwicklung 10 anpassen (Simulationsphase).

Erreicht die Kondensatorspannung die Schwelle UP', dann schaltet der Operationsverstärker 15 wieder durch und es schließt sich die nächste Stromflußphase des Feldeffekttransistors 11 an.

Zur Realisierung des anfänglichen Anzugsstromes, der über dem nachfolgenden Haltestrom liegt, dient der Hochpaß mit dem Kondensator 35 und dem Widerstand 37. Mit ihm wird der Anfangsschwellwert des Operationsverstärkers 15 entsprechend der Dimensionierung erhöht.

Im Kurzschlußfall kommt der Widerstand 38 parallel zur Magnetwicklung 10 zum Tragen. Sein relativ niedriger Widerstandswert bewirkt ein rasches Ansteigen der Spannung über dem Kondensator 17, die Schwellspannung des Operationsverstärkers 15 wird in kurzer Zeit erreicht und es entstehen dadurch nur sehr kurze Einschaltimpulse am Feldeffekttransistor 11. Der nächste Einschaltimpuls kommt erst dann, wenn entsprechend der Simulationsphase für das korrekt angeschlossene Magnetventil die Spannung über dem Kondensator 17 wieder abgefallen ist. Infolgedessen reduziert sich die mittlere Verlustleistung im Feldeffekttransistor auch im Kurzschlußfall auf einen minimalen Wert.

**Temperaturkompensation**

MOS-Transistoren, insbesondere Sip-MOS-Transistoren haben einen definierten Widerstandswert im leitenden Zustand, der zwischen den einzelnen Exemplaren nur eine geringe Streuung aufweist. Der Temperaturkoeffizient ist positiv. Durch die thermische Kopplung der Dioden 25 und 26, deren Temperaturkoeffizient negativ ist, erreicht man eine Temperaturkompensation und damit einen temperaturunabhängigen Signalverlauf über dem Kondensator 17. Bei einer Integration der beiden Dioden 25 und 26 auf dem MOS-Chip eventuell zusammen mit der Gesamtschaltung wäre diese Kombination somit optimal. Unter Umständen würde dann auch eine Diode genügen.

Eine Kompensation des Temperaturverhaltens des Feldeffekttransistors 11 kann dann entfallen, wenn nur der Kurzschluß des Magnetventils 10 erkannt werden soll oder jedoch die Ansteuerspannung durch einen überlagerten Regelkreis die Drift ausgleicht.

Figur 4 zeigt gegenüber Figur 3 insoweit einen geänderten Gegenstand, als dort zwischen Kondensator 17 und den Dioden 25 und 26 die Kollektor-Emitter-Strecke eines Transistors 40 liegt. Basisseitig steht dieser Transistor 40 über einen Widerstand 41 mit dem Ausgang des Operationsverstärkers 15 in Verbindung. Parallel zum Kondensator 17 befindet sich bei dieser Anordnung ein Widerstand 42, der die Entladung des Kondensators 17 bestimmt. Emitterseitig steht der Transistor 40 noch über einen Widerstand 43 mit der Plusleitung 32 in Verbindung.

Prinzipiell entspricht die in Figur 4 dargestellten Anordnung denen der Figuren 1 und 3. Unterschiedlich ist lediglich die Realisierung des Schalters 19 von Figur 1, wobei während der Entladephase des Kondensators 17 zusätzlich ein parallel liegender Widerstand 42 zum Tragen kommt.

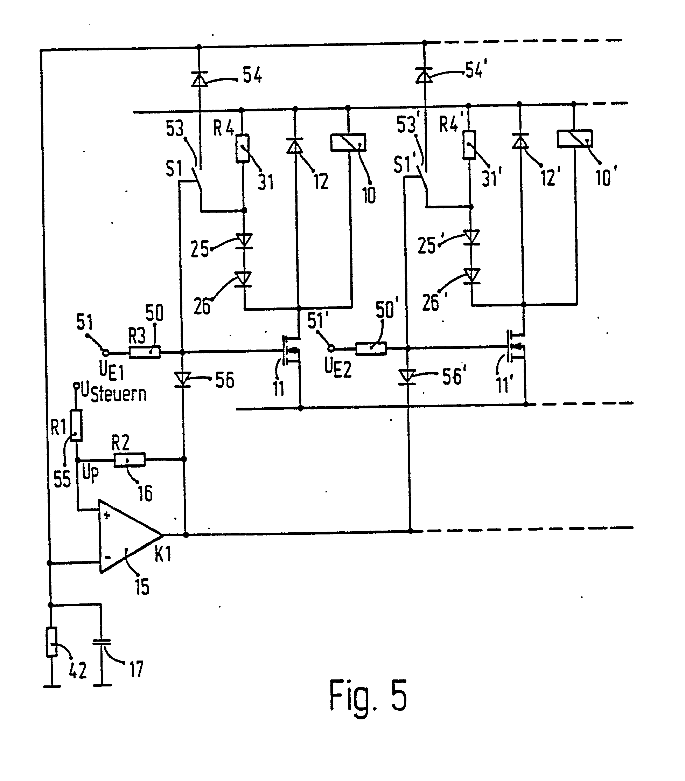

Figur 5 zeigt eine Mehrfachanordnung von gesteuerten elektromagnetischen Ventilen. Der Feldeffekttransistor 11 wird dort über einen speziellen Widerstand 50 aus einer Anschlußklemme 51 mit einem Schaltsignal versorgt, das die Gesamtdauer des Einspritzimpulses wiedergibt. Die übrige Beschaltung dient dazu, während dieser gesamten Dauer des Einspritzimpulses den Feldeffekttransistor 11 zu takten und damit den Stromfluß durch die Magnetwicklung 10 zu drosseln. Erkennbar sind wieder der Operationsverstärker 15 mit einem Kondensator 17 und parallel liegendem Widerstand 42. Der Magnetwicklung 10 liegt eine Reibenschaltung der beiden Dioden 25 und 26 sowie des Widerstandes 31 parallel. Von der Verbindungsstelle der Diode 25 und des Widerstandes 31 führt ein Schalter 53 und eine Diode 54 zum Minus-Eingang des Operationsverstärkers 15, an dem auch das RC-Glied angeschlossen ist. Der Plus-Eingang des Operationsverstärkers 15 erhält über einen Widerstand 55 ein Schwellensteuersignal und ausgangsseitig ist er über eine Diode 56 mit dem Gate-Anschluß des Feldeffekttransistors 11 gekoppelt. Angesteuert wird der Schalter 53 ebenfalls vom Gate-Signal. Wesentlich beim Gegenstand von Figur 5 ist nun, daß der Teilbereich, der die Bauelemente 10, 11, 12, 25, 26, 31 und 50 bis 56 umfaßt, doppelt ausgeführt ist und auch beliebig erweiterbar ist, wobei über die jeweiligen Anschlußklemmen 51 und 51' die einzelnen Einspritzventile mit den Magnetwicklungen 10 und 10' getrennt voneinander steuerbar sind. Für den Fall, daß sich die Schaltsignale für die Magnetwicklungen 10 und 10' nicht überlappen, kommt man mit einer einzigen Meß-Simulationseinheit aus, die das RC-Glied 17, 42 und den Operationsverstärker 15 umfaßt.

Die oben beschriebenen Schaltungsanordnungen haben sich insoweit als vorteilhaft erwiesen, als sie keinen gesonderten Meßwiderstand für den Strom durch die Magnetwicklungen benötigen und dadurch kostengünstig sind. Dazu kommt die auf der Einfachheit beruhende geringe Verlustleistung im Steuergerät sowie die relativ einfache Temperaturkompensation vor allem bei einer Vollintegration der Schaltungsanordnung. Außerdem haben sich die Schaltungsanordnungen als kurzschlußsicher erwiesen.

Wenn auch die Erfindung im Zusammenhang mit einem Einspritzsystem bei einer Brennkraftmaschine beschrieben wurde, so ist hierin doch keine Beschränkung zu sehen. Sie ist überall dort einsetzbar, wo induktive Verbraucher schnell und sicher bei gleichzeitig niedrigem Bauelementeaufwand arbeiten sollen. Speziell ist dabei zusätzlich an elektromagnetische Stellelemente für Dieseleinspritzsysteme gedacht, die mit einem pulslängenmodulierten Dauersignal arbeiten. Außerdem hat sich gezeigt, daß sich die Schaltungsanordnung auch bei ohmschen und kapazitiven Verbrauchern einsetzen läßt, wenn bei gepulsten höherfrequenten Signalen die Leistungsinduktivitäten und -Kapazitäten zum Tragen kommen und die Schaltungsanordnung als Kurzschlußschutz dient.

**Patentansprüche**

1. Elektrische Schaltanordnung zur getakteten Regelung des Stromes durch einen elektromagnetischen Verbraucher in Verbindung mit einem Kraftfahrzeug mit einer Serienschaltung aus dem elektromagnetischen Verbraucher (10) und einem im geschlossenen Zustand einen endlichen Widerstandswert aufweisenden elektrischen Schalter (11) sowie mit einem den Verbraucher einbeziehenden Freilaufkreis (Freilaufdiode 12), dadurch gekennzeichnet, daß während der Zeitdauer, in der der Schalter (11) geschlossen ist, der Schalter (11) als Meßorgan für den Strom durch den Verbraucher verwendet wird, daß Mittel zur Darstellung des zeitlichen Verlaufs des Stroms durch den Verbraucher, insbesondere ein RC-Glied (17, 21, 28), vorhanden sind, daß bei Erreichen eines oberen Schwellwertes des Stromes der Schalter (11) geöffnet wird, daß während der Zeitdauer, in der der Schalter (11) geöffnet ist, der Strom durch den Verbraucher (10) simuliert wird, sowie daß, abhängig vom Erreichen eines unteren Schwellwertes des Stromes durch den Verbraucher (10), der Schalter (11) wieder geschlossen wird.

2. Schaltanordnung nach Anspruch 1, dadurch gekennzeichnet, daß während der Zeitdauer, in der der Schalter (11) geöffnet ist, der Strom durch den elektromagnetischen Verbraucher (10) mit Hilfe eines RC-Glieds (17, 21, 28) simuliert wird.

3. Schaltanordnung nach Anspruch 2, dadurch gekennzeichnet, daß während der Zeitdauer, in der der Schalter (11) geschlossen ist, die Kapazität (17) des RC-Glieds aufgeladen wird, und daß während der Zeitdauer, in der der Schalter (11) geöffnet ist, diese Kapazität (17) entladen wird.

4. Schaltanordnung nach Anspruch 3, dadurch gekennzeichnet, daß die Auf- und Entladung der Kapazität (17) mittels eines Umschalters (19) gesteuert wird.

5. Schaltanordnung nach Anspruch 4, dadurch gekennzeichnet, daß die Betätigung des Umschalters (19) direkt oder indirekt abhängig ist vom Strom durch den Verbraucher (10).

6. Schaltanordnung nach Anspruch 1, dadurch gekennzeichnet, daß der Schalter (11) mit Hilfe eines positiv rückgekoppelten Operationsverstärkers (15) angesteuert wird.

7. Schaltanordnung nach Anspruch 6, dadurch gekennzeichnet, daß als Vergleichsgröße für den Strom durch den Verbraucher (10) die Spannung an der Kapazität (17) verwendet wird.

8. Schaltanordnung nach Anspruch 7, dadurch gekennzeichnet, daß der Operationsverstärker (15) jeweils dann schaltet, wenn die Spannung an der Kapazität (17) einen oberen oder unteren Grenzwert erreicht.

9. Schaltanordnung nach wenigstens einem der Ansprüche 1 bis 8, dadurch gekennzeichnet, daß der Schalter (11) in der Form eines Transistors mit einem definierten endlichen Widerstandswert seiner hauptsächlich stromführenden Strecke ausgeführt ist.

10. Schaltanordnung nach Anspruch 9, dadurch gekennzeichnet, daß der Transistor ein Feldeffekttransistor ist und daß in der die Kapazität (17) mit dem Drainanschluß (D) des Feldeffekttransistors verbindenden Leitung eine Temperaturkompensationsstufe (20) angeordnet ist.

11. Schaltanordnung nach Anspruch 10, dadurch gekennzeichnet, daß die Temperaturkompensationsstufe (20) mindestens eine Diode (25, 26) umfaßt, die thermisch mit dem Feldeffekttranstistor gekoppelt ist.

12. Schaltanordnung nach Anspruch 11, dadurch gekennzeichnet, daß die mindestens eine Diode (25; 26) zumindest mit dem Feldeffekttransistor auf dem gleichen Halbleitersubstrat zusammengefaßt ist.

13. Schaltanordnung nach wenigstens einem der Ansprüche 1 bis 12, dadurch gekennzeichnet, daß als elektromagnetischer Verbraucher (10) ein Kraftstoffzumeßorgan in der Form eines Magnetventils vorgesehen ist.

14. Schaltsanordnung nach wenigstens einem der Ansprüche 1 bis 12, dadurch gekennzeichnet, daß als elektromagnetischer Verbraucher (10) ein Kraftstoffzumeßorgan in der Form eines Stellwerks für das mengenbestimmende Glied einer Diesel-Einspritzanlage vorgesehen ist.

## Claims

1. Electric switching arrangement for the clocked controlling of the current by means of an electromagnetic load in conjunction with a motor vehicle, with a series circuit of the electromagnetic load (10) and an electric switch (11) which has a finite resistance value in the closed condition, and with a freewheeling circuit (freewheeling diode 12) which includes the load, characterized in that, during the period of time in which the switch (11) is closed, the switch (11) is used as measuring element for the current through the load, in that means exist for representing the variation in time of the current through the load, particularly an RC section (17, 21, 28), in that the switch (11) is opened when an upper threshold value of the current is reached, in that the current through the load (10) is simulated during the period of time in which the switch (11) is opened and in that the switch (11) is closed again in dependence on a lower threshold value of the current through the load (10) being reached.

2. Switching arrangement according to Claim 1, characterized in that the current through the electromagnetic load (10) is simulated with the aid of an RC section (17, 21, 28) during the period of time in which the switch (11) is opened.

3. Switching arrangement according to Claim 2, characterized in that the capacitance (17) of the RC section is charged up during the period of time in which the switch (11) is closed and in that this capacitance (17) is discharged during the period of time in which the switch (11) is opened.

4. Switching arrangement according to Claim 3, characterized in that the charging up and discharging of the capacitance (17) is controlled by means of a change-over switch (19).

5. Switching arrangement according to Claim 4, characterized in that the actuation of the change-over switch (19) is directly or indirectly dependent on the current through the load (10).

6. Switching arrangement according to Claim 1, characterized in that the switch (11) is driven with the aid of an operational amplifier (15) with positive feedback.

7. Switching arrangement according to Claim 6, characterized in that the voltage across the capacitance (17) is used as reference value for the current through the load (10).

8. Switching arrangement according to Claim 7, characterized in that the operational amplifier (15) switches whenever the voltage across the capacitance (17) reaches an upper or lower limit value.

9. Switching arrangement according to at least one of Claims 1 to 8, characterized in that the switch (11) is constructed in the form of a transistor having a defined finite resistance value of its mainly current-conducting path.

10. Switching arrangement according to Claim 9, characterized in that the transistor is a field-effect transistor and in that a temperature-compensation stage (20) is arranged in the line connecting the capacitance (17) to the drain connection (D) of the field-effect transistor.

11. Switching arrangement according to Claim 10, characterized in that the temperature compensation stage (20) comprises at least one diode (25, 26) which is thermally coupled to the field-effect transistor.

12. Switching arrangement according to Claim 11, characterized in that at least one diode (25; 26) is at least combined with the field-effect transistor on the same semiconductor substrate.

13. Switching arrangement according to at least one of Claims 1 to 12, characterized in that a fuel feeding element in the form of a solenoid valve is provided as electromagnetic load (10).

14. Switching arrangement according to at least one of Claims 1 to 12, characterized in that a fuel feeding element in the form of an actuating mechanism for the flow-determining member of a diesel fuel injection system is provided as electromagnetic load (10).

## Revendications

1. Montage électrique pour régler de manière cadencée le courant dans un consommateur électromagnétique en liaison avec un véhicule à moteur comportant un montage en série formé du consommateur électromagnétique (10) et d'un commutateur (11) qui, à l'état branché, présente une résistance finie, ainsi qu'un circuit de roue libre (diode de roue libre 12) faisant partie du consommateur, montage caractérisé en ce que pendant la durée de fermeture du commutateur (11), ce commutateur (11) est utilisé comme organe de mesure du courant traversant le consommateur, des moyens étant prévus pour représenter le tracé dans le temps du courant à travers le consommateur, notamment un élément RC (17, 21, 28), et en ce que lorsqu'on atteint un seuil supérieur pour le courant, le commutateur (11) est ouvert et en ce que pendant la durée d'ouverture du commutateur (11), on simule le courant traversant le consommateur (10) et en ce que, en fonction de ce que le courant atteint un seuil inférieur à travers le consommateur (10), on ferme de nouveau le commutateur (11).

2. Montage selon la revendication 1, caractérisé en ce que pendant la durée d'ouverture du commutateur (11), on simule le courant à travers le consommateur électromagnétique (10) à l'aide d'un élément RC (17, 21, 28).

3. Montage selon la revendication 2, caractérisé en ce que pendant la durée de fermeture du commutateur (11), on charge le condensateur (17) de l'élément RC et pendant la durée d'ouverture du commutateur (11), on décharge ce condensateur (17).

4. Montage selon la revendication 3, caractérisé en ce que la charge et la décharge du condensateur (17) sont commandées à l'aide d'un inverseur (19).

**0 074 536**

5. Montage selon la revendication 4, caractérisé en ce qu'on actionne l'inverseur (19) directement ou indirectement en fonction du courant traversant le consommateur (10).

6. Montage selon la revendication 1, caractérisé en ce qu'on commande le commutateur (11) a l'aide d'un amplificateur opérationnel (15) à réaction positive.

7. Montage selon la revendication 6, caractérisé en ce que comme grandeur de comparaison du courant à travers le consommateur (10), on a la tension aux bornes du condensateur (17).

8. Montage selon la revendication 7, caractérisé en ce que l'amplificateur opérationnel (15) commute lorsque la tension aux bornes du condensateur (17) atteint un seuil supérieur ou inférieur.

9. Montage selon au moins l'une des revendications 1 à 8, caractérisé en ce que le commutateur (11) est constitué par un transistor dont le chemin principal conducteur de courant présente une résistance finie, déterminée.

10. Montage selon la revendication 9, caractérisé en ce que le transistor est un transistor à effet de champ et en ce que le condensateur (17) est relié par un conducteur comprenant la borne de drain (D) du transistor à effet de champ sur un étage de compensation de température (20).

11. Montage selon la revendication 10, caractérisé en ce que l'étage de compensation de température (20) comprend au moins une diode (25, 26) couplée de manière thermique sur le transistor à effet de champ.

12. Montage selon la revendication 11, caractérisé en ce qu'au moins une diode (25, 26) est réunie avec au moins le transistor à effet de champ sur le même support semi-conducteur.

13. Montage selon au moins l'une des revendications 1 à 12, caractérisé en ce que le consommateur electromagnetique (10) est un organe de dosage de carburant sous la forme d'une électrovanne.

14. Montage selon au moins l'une des revendications 1 à 12, caractérisé en ce que le consommateur electromagnétique (10) est un organe de mesure de carburant sous la forme d'un organe de réglage pour un élément de détermination de quantité d'une installation d'injection Diesel.

Fig. 1

Fig. 2a

Fig. 2b

Fig. 3

Fig. 4

Fig. 5